# EUROPÄISCHE PATENTSCHRIFT

(11) **EP 1 596 642 B1**
(45) Veröffentlichungstag und Bekanntmachung des Hinweises auf die Patenterteilung: **29.06.2011**
(21) Anmeldenummer: 05007603.3
(22) Anmeldetag: 07.04.2005
(51) Int. Cl.: H01R 9/00, H05K 5/00

(54) **Elektronikgehäuse mit Steuerplatine für ein Haushaltgerät**
Electronic housing wih control panel for domestic appliance
Boîtier électronique avec une plaque de commande pour un appareil ménager

(30) Priorität: 03.05.2004 DE 102004021991
(43) Veröffentlichungstag der Anmeldung: 16.11.2005
(73) Patentinhaber: Miele & Cie. KG, 33332 Gütersloh (DE)
(72) Erfinder: Evertzberg, Frank, 33428 Marienfeld (DE)

(56) Entgegenhaltungen:
- EP-A- 0 727 931
- DE-A1- 3 809 605
- FR-A- 2 840 735
- US-A- 5 076 796

## Beschreibung

Die Erfindung betrifft ein Elektronikgehäuse mit Steuerplatine für ein Haushaltgerät, wobei das Elektronikgehäuse aus einem kastenartigen Gehäuse besteht, in dem eine Leiterkarte eingefasst ist. Die Kontaktierungen an der Leiterkarte zum Gehäusedeckel sind so ausgerichtet, dass die Kontaktierungen mit Steckbereichen am Gehäusedeckel zusammenwirken.

Bei diesen Elektronikgehäusen, in denen eine Steuerplatine für ein Haushaltgerät, wie beispielsweise eine Geschirrspülmaschine, eingefasst ist, ergibt sich das Problem, dass das Gehäuse einerseits und die als Leiterkarte ausgebildete Steuerplatine andererseits unterschiedliche Wärmeausdehnungskoeffizienten aufweisen. So kommt es bei Erwärmung des Elektronikgehäuses und der Steuerplatine zu Relativbewegungen zwischen den Bauteilen. Dies führt dann im Bereich der Kontaktierungen zu Kontaktverschleißungen, so dass ein gesicherter Programmablauf bei dem Haushaltgerät nicht mehr gegeben ist. Mit anderen Worten bedeutet das, dass insbesondere die Steckkontakte, die einerseits mit dem Gehäuse in Wirkverbindung stehen und andererseits mit der Leiterkarte, Relativbewegungen unterliegen, und infolge der sich ergebenden Reibung in der Kontaktfläche es in diesem Bereich zu Abnutzungen kommt.

Im FR 2 840 735 wird auf unterschiedliche Wärmeausdrehnungskoeffizienten in einer Platine hingewiesen.

Der Erfindung stellt sich somit das Problem, insbesondere diese wärmebedingten Verschleißerscheinungen in einem Elektronikgehäuse mit Steuerplatine für ein Haushaltgerät zu unterbinden.

Erfindungsgemäß wird dieses Problem mit den Merkmalen des Anspruchs 1 gelöst. Vorteilhafte Ausgestaltungen und Weiterbildungen der Erfindung ergeben sich aus den nachfolgenden Unteransprüchen.

Die mit der Erfindung erreichbaren Vorteile ergeben sich dadurch, dass die Steckbereiche des Gehäusedeckels bei Erwärmung des gesamten Elektronikgehäuses einerseits, sowie der Leiterkarte andererseits, eine Bewegung in Bezug zu den Kontaktierungen an der Leiterkarte zulassen. Hierdurch wird erreicht, dass insbesondere die Kontaktbereiche kaum noch einer Relativbewegung mehr unterliegen und es in diesem Bereich zu keiner abnutzenden Reibung mehr kommen kann, die insbesondere Fehlsteuerungen oder Ausfälle hervorrufen könnte.

Dabei sind die Steckbereiche in der Fläche des Gehäusedeckels derart eingebunden, dass sie eine Relativbewegung gegenüber dem restlichen Gehäusedeckel vollziehen können. Um die schwimmende Lagerung der Steckbereiche zu ermöglichen, stehen die Steckbereiche über aus der Fläche des Gehäusedeckels herausgeformten dünnen Rippen mit dem restlichen Gehäusedeckel in flexibler Anbindung. Es versteht sich nun von selbst, dass aufgrund der vorgenommenen Materialaussparung im Steckbereich, dieser nur noch durch Rippen mit dem restlichen Gehäusedeckel in Verbindung steht. Diese Rippen lassen eine parallelogrammartige Verschiebung der Steckbereichsleiste zu, so dass die darin angeordneten Kontakte mit der sich ausdehnenden Leiterkarte mitwandern.

Um insbesondere eine abgestimmte Bewegung der Steckbereiche zu der sich bewegenden Leiterkarte bei Erwärmung zu erreichen, sind an dem flexibel gehaltenen Steckbereich Mitnehmer in Form von angeformten Stiften angeformt, die durch Öffnungen in der Leiterkarte ragen. Die Stifte wiederum wirken mit angeformten Rastnasen am kastenförmigen Gehäuse zusammen. Dadurch wird sichergestellt, dass, wenn die Leiterkarte eine Längenänderung infolge der Erwärmung erfährt, hier die flexibel gehaltenen Steckbereiche entsprechend der Wärmeausdehnung mitgenommen werden. Nach einer besonders vorteilhaften Weiterbildung der Erfindung ist der Steckbereich aus einzelnen Steckwannen gebildet, die sich über den Gehäusedeckelrandbereich erstrecken. Um die Gehäuse sicher zusammen zu halten, sind am Gehäusedeckelbereich zusätzliche Rastnasen zur Festlegung an dem kastenförmigen Gehäuse angeformt. Die Kontaktierung des Kabelbaumes mit der Elektronik der Leiterkarte erfolgt an die Steckbereiche durch eine Direktsteckung.

Ein Ausführungsbeispiel der Erfindung ist in den Figuren rein schematisch dargestellt und wird nachfolgend näher beschrieben. Es zeigen:
- Figur 1:: eine Explosionszeichnung des Elektronikgehäuses mit Leiterkarte;
- Figur 2:: eine perspektivische Darstellung des Gehäusedeckels;
- Figur 3:: eine perspektivische Darstellung des Gehäusedeckels, gemäß der Figur 2 mit Einbindung einer Leiterkarte;
- Figur 4:: eine Ansicht des Gehäusedeckels in Richtung auf die Steckbereiche;
- Figur 5:: eine Unteransicht des Gehäusedeckels;
- Figur 6:: eine Ansicht des Gehäusedeckels, gemäß der Figur 4, mit Einbindung einer Leiterkarte und
- Figur 7:: eine Unteransicht des Gehäusedeckels mit eingebundener Leiterkarte.

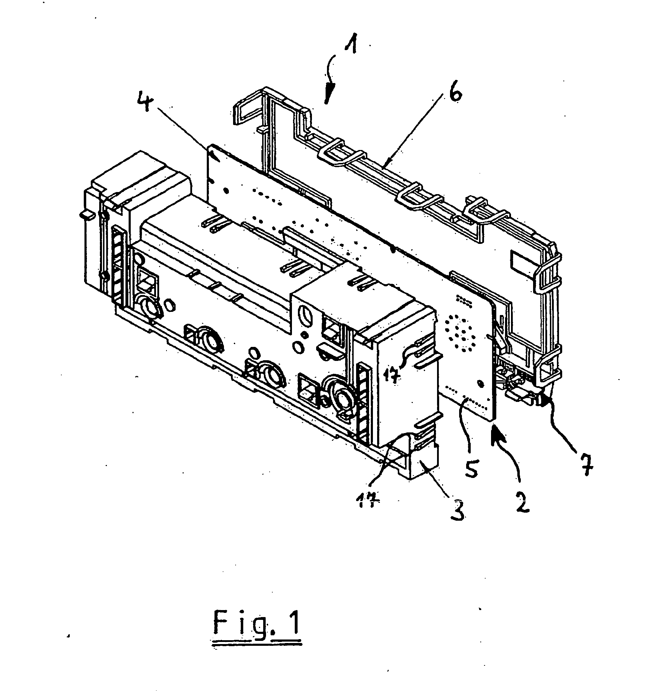

Die Figur 1 zeigt ein Elektronikgehäuse 1 mit einer Steuerplatine 2 für eine nicht näher dargestellte Geschirrspülmaschine. Das Elektronikgehäuse 1 besteht dabei aus einem kastenförmigen Gehäuse 3, in dem eine Leiterkarte 4 eingefasst ist. Die Kontaktierungen 5 an der Leiterkarte 4 sind dabei zum Gehäusedeckel 6 so ausgerichtet, dass die Kontaktierungen 5 mit Steckbereichen 7 am Gehäusedeckel 6 zusammenwirken.

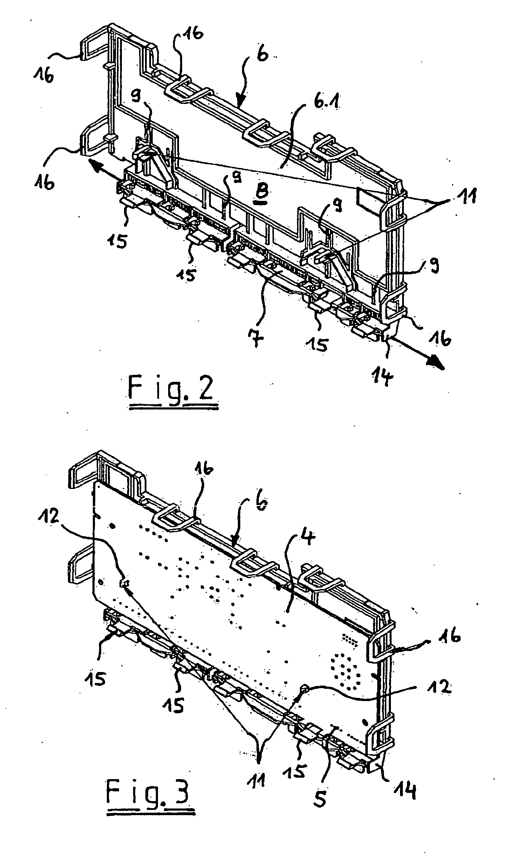

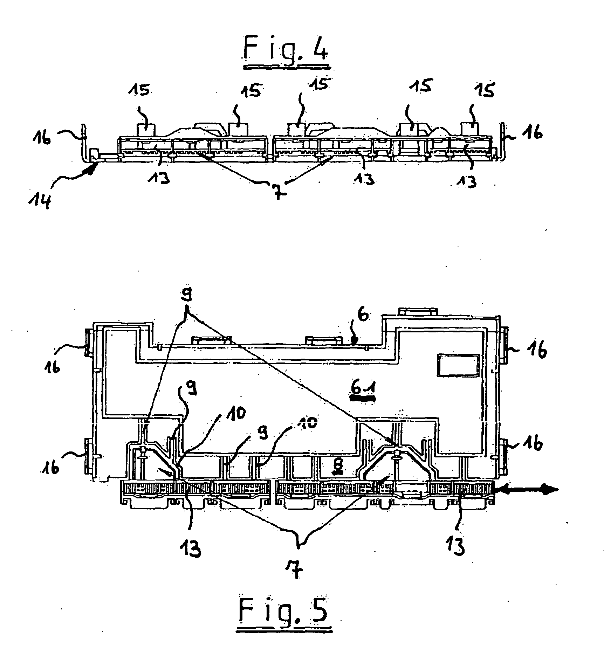

Gemäß der Erfindung wird nun vorgesehen, dass die Steckbereiche 7 (besser zu erkennen in der Figur 2) des Gehäusedeckels 6 bei Erwärmung des Elektronikgehäuses 1 einerseits, sowie der Leiterkarte 4 andererseits, eine Bewegung gemäß der angegebenen Pfeilrichtungen in Bezug zu den Kontaktierungen 5 an der Leiterkarte 4 zulassen. Wie aus der Figur 5 in der Draufsicht zu erkennen ist, sind die Steckbereiche 7 in der Fläche des Gehäusedeckels 6 derart eingebunden, dass eine Relativbewegung gegenüber dem restlichen Gehäusedeckelteil 6.1 möglich ist. Wie aus der Figur 2, aber auch aus der Figur 5 zu erkennen ist, stehen die Steckbereiche 7 über aus der Fläche 8 des Gehäusedeckels 6 herausgeformten dünnen Rippen 9 mit dem restlichen Gehäuseteil 6.1 in flexibler Anbindung. Infolge der Materialaussparungen 10 ist der Steckbereich 7 ausschließlich über die Rippen 9 an dem restlichen Gehäuseteil 6.1 angebunden.

Es versteht sich nun von selbst, dass der Steckbereich 7 als solches etwas federnd gelagert ist, wobei der Federweg durch die Materialaussparungen 10 begrenzt ist. Somit ergibt sich eine schwimmende Lagerung des Steckbereiches 7 an dem restlichen Gehäusedeckelteil 6.1.

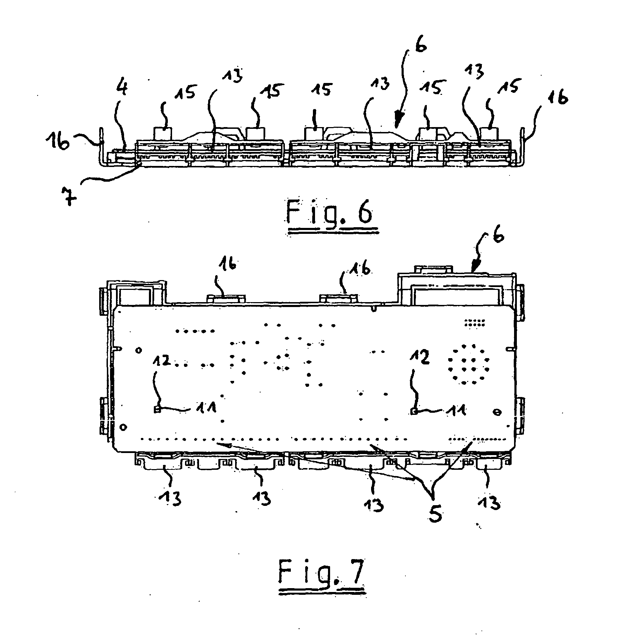

Gemäß der Figuren 3 und 7, die insbesondere die Einbindung der Leiterkarte 4 im Gehäusedeckel 6 zeigen, wird die Einbindung des Gehäusedeckels 6, sowie des flexibel gehaltenen Steckbereichs 7 erkennbar. An dem flexibel gehaltenen Steckbereich 7 sind Mitnehmer in Form von Stiften 11 angeformt, die durch Öffnungen 12 in der Leiterkarte 4 ragen.

Wie aus den Figuren 4 und 5 zu erkennen ist, wird der Steckbereich 7 aus einzelnen Steckwannen 13 gebildet, die sich über den Gehäusedeckelrandbereich 14 erstrecken. Dabei sind im Bereich des Gehäusedeckelrandbereiches 14 sogenannte Rasthaken 15 angeformt, die in nicht näher erkennbare Nuten am kastenförmigen Gehäuse 3 greifen. Um den Gehäusedeckel 6 am kastenförmigen Gehäuse 3 festzulegen, sind am Gehäusedeckel 6 Rastbügel 16 vorgesehen, die wiederum mit angeformten Keilen 17 an der Außenwand des kastenförmigen Gehäuses 3 zusammenwirken. Es versteht sich von selbst, dass, wenn die Rastbügel 16 aufgedrückt werden, diese die angeformten Keile 17 hintergreifen.

Aus der Zusammenschau der Figuren 1 bis 7 wird nun deutlich, dass, wenn beispielsweise das Elektronikgehäuse 1 mit Temperatur beaufschlagt wird, wobei auch die Leiterkarte von der Temperaturerhöhung erfasst wird, diese um einen Betrag gelängt wird, und infolge dieser Längenänderung der Steckbereich 7 und somit die einzelnen Steckwannen 13, die Längenänderung der Leiterkarte 4 mit vollziehen, weil sie angebunden sind durch die Stifte 11, wobei die Längenänderung getragen wird von den Rippen 9. Die Kontaktflächen der Kontaktierungen 5 auf der Leiterkarte 4 nehmen somit die Steckwannen 13 mit, so dass eine Relativbewegung an den Kontaktflächen nicht auftritt.

## Patentansprüche

1. Elektronikgehäuse mit Steuerplatine für ein Haushaltgerät, wobei das Elektronikgehäuse aus einem kastenartigen Gehäuse besteht, in dem eine Leiterkarte eingefasst ist, die als Steuerplatine für das Haushaltgerät eingesetzt wird, und wobei Kontaktierungen an der Leiterkarte zum Gehäusedeckel so ausgerichtet sind, dass die Kontaktierungen mit Steckbereichen am Gehäusedeckel zusammenwirken,
und wobei
die Steckbereiche (7) des Gehäusedeckels (6) bei Erwärmung des Elektronikgehäuses (1) einerseits sowie der Leiterkarte (4) andererseits dadurch eine Bewegung mit den Kontaktierungen (5) der Leiterkarte (4) vollziehen, dass die Steckbereiche (7) in der Fläche (8) des Gehäusedeckels (6) derart eingebunden sind, dass eine Relativbewegung gegenüber dem restlichen Gehäusedeckelteil (6.1) mit Hilfe von aus der Fläche (8) des Gehäusedeckels (6) herausgeformten dünnen Rippen (9), die die Steckbereiche (7) mit dem restlichen Gehäusedeckelteil (6.1) in einer flexiblen Art verbinden, möglich ist, und wobei die Steckbereiche (7) und die Leiterkarte (4) durch Stifte (11) angebunden sind, die durch Öffnungen (12) in der Leiterkarte (4) ragen.

2. Elektronikgehäuse nach Anspruch 1,
**dadurch gekennzeichnet,**
**dass** der Steckbereich (7) aus einzelnen Steckwannen (13) gebildet ist, die sich über den Gehäusedeckelrandbereich (14) erstrecken.

3. Elektronikgehäuse nach Anspruch 2,
**dadurch gekennzeichnet,**
**dass** am Gehäusedeckelrandbereich (14) Rastbügel (16) zur Festlegung an dem kastenförmigen Gehäuse (3) angeformt sind.

4. Elektronikgehäuse nach einem oder mehreren der Ansprüche 1 bis 3,
**dadurch gekennzeichnet,**
**dass** die Kontaktierung (5) des Kabelbaumes mit der Elektronik der Leiterkarte (4) durch Direktsteckung erfolgt.

## Claims

1. Electronic housing comprising a control printed circuit board for a domestic appliance, wherein the electronic housing consists of a box-like housing in which a printed circuit board, which is used as a control printed circuit board for the domestic appliance, is fitted, and wherein connectors on the printed circuit board are oriented relative to the housing lid in such a way that the connectors cooperate with connection regions on the housing lid, and wherein, when both the electronic housing (1) and the printed circuit board (4) are heated, the connection regions (7) of the housing lid (6) move with the connectors (5) of the printed circuit board (4) since the connection regions (7) are integrated in the face (8) of the housing lid (6) in such a way that it is possible to carry out a movement relative to the rest of the housing lid part (6.1) with the aid of thin ribs (9) which are formed from the face (8) of the housing lid (6) and connect the connection regions (7) to the rest of the housing lid part (6.1) in a flexible manner, and wherein the connection regions (7) and the printed circuit board (4) are fastened by pins (11) which project through openings (12) in the printed circuit board (4).

2. Electronic housing according to claim 1, **characterised in that** the connection region (7) is formed of individual connection compartments (13) which extend over the housing lid edge region (14).

3. Electronic housing according to claim 2, **characterised in that** locking clips (16) for fastening to the box-like housing (3) are integrally formed on the housing lid edge region (14).

4. Electronic housing according to one or more of claims 1 to 3, **characterised in that** the cable harness is connected (5) to the electronics of the printed circuit board (4) by being plugged in directly.

## Revendications

1. Boîtier électronique avec carte de commande pour un appareil ménager, dans lequel le boîtier électronique est composé d'un boîtier de type caisson dans lequel est montée une carte imprimée qui est utilisée comme carte de commande pour l'appareil ménager, et dans lequel des contacts sont orientés sur la carte imprimée vers le couvercle de boîtier de sorte que les contacts coopèrent avec des zones de connexion sur le couvercle de boîtier,
et dans lequel les zones de connexion (7) du couvercle de boîtier (6) lors de l'échauffement du boîtier électronique (1) d'un côté ainsi que de la carte imprimée (4) de l'autre côté effectue un mouvement avec les contacts (5) de la carte imprimée (4) du fait que les zones de connexion (7) sont reliées dans la surface (8) du couvercle de boîtier (6) de sorte qu'un mouvement relatif par rapport à la partie de couvercle de boîtier (6.1) résiduelle est possible à l'aide de nervures (9) minces formées à partir de la surface (8) du couvercle de boîtier (6) qui raccordent de façon flexible les zones de connexion (7) à la partie de couvercle de boîtier (6.1) résiduelle, et dans lequel les zones de connexion (7) et la carte imprimée (4) sont attachées par des broches (11) qui dépassent à travers des ouvertures (12) dans la carte imprimée (4).

2. Boîtier électronique selon la revendication 1,
**caractérisé en ce que**
la zone de connexion (7) est constituée de cuves de connexion (13) individuelles qui s'étendent sur la zone marginale de couvercle de boîtier (14).

3. Boîtier électronique selon la revendication 2,
**caractérisé en ce que**
des étriers d'accrochage (16) sont formés sur la zone marginale de couvercle de boîtier (14) pour la fixation sur le boîtier (3) en forme de caisson.

4. Boîtier électronique selon l'une ou plusieurs des revendications 1 à 3,
**caractérisé en ce que**
la contact (5) du faisceau de câbles avec l'électronique de la carte imprimée (4) s'effectue par connexion directe.
